# EUROPÄISCHE PATENTSCHRIFT

(11) **EP 0 844 945 B1**
(45) Veröffentlichungstag und Bekanntmachung des Hinweises auf die Patenterteilung: **24.10.2001**
(21) Anmeldenummer: 96911920.5
(22) Anmeldetag: 25.04.1996
(51) Int. Cl.: B60R 21/00, B60R 16/02, G01R 27/00, G01R 31/02

(54) **ANORDNUNG ZUM KONTROLLIEREN DES WIDERSTANDES EINER AN EINEM ÜBERTRAGER ANGESCHLOSSENEN LAST**
SYSTEM FOR CONTROLLING THE RESISTANCE OF A LOAD CONNECTED TO A TRANSFORMER
SYSTEME DE CONTROLE DE LA RESISTANCE D'UNE CHARGE RACCORDEE A UN TRANSFORMATEUR

(30) Priorität: 19.08.1995 DE 19530586
(43) Veröffentlichungstag der Anmeldung: 03.06.1998
(73) Patentinhaber: ROBERT BOSCH GMBH, 70442 Stuttgart (DE)
(72) Erfinder: ZABLER, Erich, D-76297 Stutensee (DE); DUKART, Anton, D-76744 Wörth (DE)
(86) Internationale Anmeldenummer: DE9600722
(87) Internationale Veröffentlichungsnummer: WO9706978

(56) Entgegenhaltungen:
- WO-A-87/07388
- DE-A- 3 540 031
- DE-A- 3 812 633
- FR-A- 2 576 109

## Beschreibung

### Stand der Technik

Die vorliegende Erfindung betrifft eine Anordnung zum Kontrollieren des Widerstandes einer an einem Übertrager sekundärseitig angeschlossenen Last - vorzugsweise der Zündpille eines Airbags

Eine derartige Anordnung ist aus der DE 38 12 633 A1 bekannt. Gemäß diesem Stand der Technik wird beispielsweise zur Signalübertragung zwischen einem Steuergerät und einem in einem Lenkrad eines Fahrzeugs eingebauten Airbag ein Drehübertrager verwendet. Die Funktionsfähigkeit eines Airbags ist ständig zu überprüfen, damit er in jeder Notfallsituation sofort einsatzbereit ist. Dazu wird der Widerstand der Zündpille, der typischerweise im Bereich von 1,8 Ω bis 2,5 Ω liegen soll, einer ständig wiederkehrenden Messung unterzogen. Die Übertragung von Signalen mittels der induktiv gekoppelten Wicklungen des Drehübertragers ist vom Abstand der beiden Wicklungen, das heißt der Größe des Luftspalts zwischen den Schalenkernen der Wicklungen, abhängig. Einbau- und Fertigungstoleranzen des Lenkrades, an dem der sekundärseitige Schalenkern des Drehübertragers installiert ist, können zu einer Verfälschung des gemessenen Widerstandswertes der Zündpille führen. Um solche Meßsignalverfälschungen zu vermeiden, sieht der genannte Stand der Technik einen Schwingkreis auf der Sekundärseite des Drehübertragers vor, der von der Primärseite aus von einem Steuersignal angeregt wird. Nach Abschalten des Steuersignals wird das Abklingen der Antwortsignale des Schwingkreises auf die Primärseite zurückübertragen und aus der Zeitkonstanten des abklingenden Antwortsignals der sekundärseitige Widerstand ermittelt.

### Vorteile der Erfindung

Gemäß Anspruch 1 findet eine Kontrolle des Widerstandes einer an einem Übertrager sekundärseitig angeschlossenen Last - vorzugsweise der Zündpille eines Airbags - mittels eines der Last parallelgeschalteten zusätzlichen Widerstandes statt, dessen ohmscher Widerstand mindestens zehnmal so groß ist wie der Lastwiderstand. Der primärseitig gemessene Eingangswiderstand des Übertragers zeigt eine eindeutige Abhängigkeit von der Größe des Lastwiderstandes. Dieser Eingangswiderstand wird gemessen und bei Abweichung von einem vorgegebenen Wert signalisiert, daß eine Fehlfunktion der Last gegeben ist.

Vorteilhafte Weiterbildungen der Erfindung gehen aus den Unteransprüchen hervor. Danach ist es zweckmäßig, den zusätzlichen Widerstand in einem die Sekundärwicklung des Übertragers aufnehmenden Schalenkern zu integrieren. Außerdem kann der zusätzliche Widerstand über eine zusätzliche Sekundärwicklung auf die Primärseite des Übertragers transformiert werden. Dabei ist es zweckmäßig, die zusätzliche Sekundärwicklung aus einem Draht zu wickeln, der selbst diesen zusätzlichen Widerstand aufweist. Der zusätzliche Widerstand kann aber auch als ein sekundärseitig angeordneter Ring ausgebildet sein. Ein Vorteil der erfindungsgemäßen Anordnung ist, daß sie mit einem sehr geringen Schaltungsaufwand realisierbar ist und eine zuverlässige Aussage über Änderungen des Lastwiderstandes ermöglicht.

### Beschreibung von Ausführungsbeispielen

Anhand mehrerer in der Zeichnung dargestellter Ausführungsbeispiele wird nachfolgend die Erfindung näher erläutert.
Figur 1 zeigt die Abhängigkeit des primärseitig gemessenen Eingangswiderstandes von einem sekundärseitig angeschlossenen Lastwiderstand,
Figur 2 zeigt einen Übertrager mit einer Sekundärwicklung und einer daran angeschlossenen Parallelschaltung eines Lastwiderstandes und eines zusätzlichen Widerstandes,
Figur 3 und 4 zeigen Übertrager mit zwei Sekundärwicklungen, von denen eine mit einem Lastwiderstand beschaltet ist und die andere Sekundärwicklung einen zusätzlichen Widerstand aufweist, und
Figur 5 zeigt einen Übertrager, der neben einer ersten mit dem Lastwiderstand beschalteten Sekundärwicklung einen den zusätzlichen Widerstand realisierenden sekundärseitigen Ring aufweist.

Wie einleitend dargelegt, soll von der Primärseite eines Übertragers her ein an dessen Sekundärseite angeschlossener Lastwiderstand auf Änderungen hin kontrolliert werden. Der Übertrager sei beispielsweise ein Drehübertrager, der zwischen einem mit einem Airbag ausgestatteten Lenkrad und der feststehenden Lenksäule angeordnet ist. Die sekundärseitig angeschlossene Last entspricht dann dem Widerstand einer Zündpille des Airbags. Eine solche Zündpille hat im Normalfall einen Widerstand von ca. 2 Ω. Ändert sich der Widerstand der Zündpille, so deutet das darauf hin, daß die Funktion des Airbags gestört ist. Eine solche Situation muß im Fahrzeug signalisiert werden. Die Kontrolle des Zündpillenwiderstandes wird stetig wiederkehrend durchgeführt.

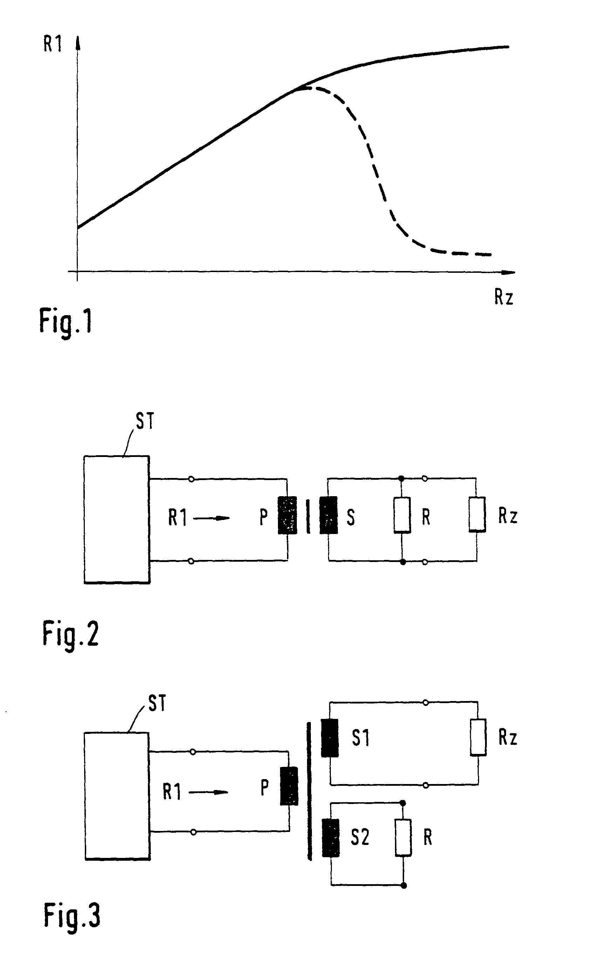

Der primärseitig gemessene Eingangswiderstand R1 eines Übertragers (mit nahezu keinen Eisenverlusten) hat die in Figur 1 schematisch dargestellte Abhängigkeit vom sekundärseitig angeschlossenen Lastwiderstand Rz. Wie der Figur 1 zu entnehmen ist, besteht zwischem dem primärseitigen Eingangswiderstand R1 und dem sekundärseitigen Lastwiderstand Rz für kleine Lastwiderstände ein linearer Zusammenhang. Nimmt der Widerstand Rz der Last jedoch stärker zu, z.B. weil sein Anschluß an die Sekundärwicklung teilweise oder total unterbrochen ist, so fällt der Eingangswiderstand auf einen kleinen Wert ab, der in etwa dem Wirkwiderstand der Primärwicklung entspricht. Die Abhängigkeit des Eingangswiderstandes R1 vom Lastwiderstand Rz nimmt dann etwa den strichliert gezeichneten Verlauf an. Es besteht nun kein eindeutiger Zusammenhang mehr zwischen dem gemessenen Eingangswiderstand R1 und dem Widerstand Rz der sekundärseitig angeschlossenen Last. Dieser Mangel kann dadurch behoben werden, daß dem Lastwiderstand Rz ein zusätzlicher Widerstand R parallelgeschaltet wird (vgl. Figur 2). Der zusätzliche Widerstand R sollte mindestens zehnmal so groß sein wie der Lastwiderstand Rz. Dann stellt sich der in Figur 1 mit einer durchgezogenen Linie dargestellte Verlauf ein, der einen eindeutigen Zusammenhang zwischen dem Eingangswiderstand R1 und dem Lastwiderstand Rz zeigt.

Ist beispielsweise die sekundärseitig angeschlossene Last Rz die Zündpille eines Airbags, dessen Widerstand im Normalfall bei ca. 2 Ω liegt, so wählt man zweckmäßig einen zusätzlichen Widerstand R von ca. 100 Ω. Da bei der Messung des Eingangswiderstandes R1 lediglich eindeutig festgestellt werden muß, ob der Zündpillenwiderstand größer 5 oder 6 Ω ist (das entspricht einer Fehlfunktion), ist es ohne Belang, daß der Eingangswiderstand R1 für weit größere Lastwiderstände Rz auf einem konstanten höheren Wert bleibt.

Voraussetzung für eine fehlerfreie Kontrolle des Lastwiderstandes ist natürlich, daß der zusätzliche Widerstand R von Störungen, das heißt z.B. Kontaktunterbrechungen, möglichst verschont bleibt. Welche Möglichkeiten es für die Anschaltung des zusätzlichen Widerstandes R gibt, verdeutlichen die Figuren 2 bis 5.

In der Figur 2 ist schematisch ein Übertrager mit seiner Primärwicklung P und seiner Sekundärwicklung S dargestellt. Dem an die Sekundärwicklung S angeschlossenen Lastwiderstand Rz ist der zusätzliche Widerstand R parallelgeschaltet. An die Primärwicklung P ist eine Steuerschaltung ST angeschlossen, welche mit bekannten Mitteln die Messung des primärseitigen Eingangswiderstandes R1 des Übertragers vornimmt. Um den zusätzlichen Widerstand R mechanisch gut gegen Kontaktunterbrechungen zu schützen, ist es zweckmäßig, ihn in einem die Sekundärwicklung aufnehmenden Schalenkern zu integrieren. Gemäß dem in Figur 3 dargestellten Ausführungsbeispiel sind zwei Sekundärwicklungen S1 und S2 vorgesehen. An die Sekundärwicklung S1 ist der Lastwiderstand Rz angeschaltet und an die Sekundärwicklung S2 der zusätzliche Widerstand R angeschlossen. Der zusätzliche Widerstand R steht somit in keiner galvanisch leitenden Verbindung mit dem Sekundärkreis für die Last, die möglicherweise Ursache für einen Fehler sein könnte. Der zusätzliche Widerstand R kann, wie Figur 2 andeutet, ein separater Widerstand sein, der wiederum im Sekundär-Schalenkern des Übertragers integriert sein kann. Der zusätzliche Widerstand R besteht vorzugsweise aus einem temperaturunabhängigen Material.

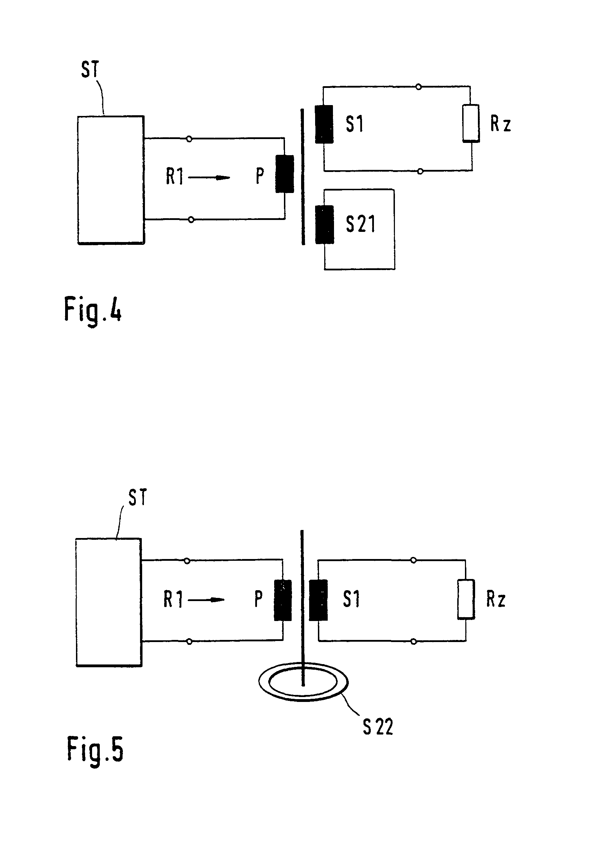

Bei dem in Figur 4 dargestellten Ausführungsbeispiel gibt es neben der für den Lastwiderstand Rz zuständigen Sekundärwicklung S1 eine zweite Sekundärwicklung S21, die selbst einen dem zusätzlichen Widerstand R entsprechenden Eigenwiderstand hat und deren Anschlüsse miteinander kurzgeschlossen sind. Diese zweite Sekundärwicklung S21 ist beispielsweise aus einem hochohmigen, temperaturunabhängigen Konstantan- oder Manganindraht gewickelt. Ein Widerstand R als zusätzliches Bauteil entfällt hiermit, wodurch sich die Störanfälligkeit erheblich verringert. Die Sekundärwicklung S21 kann in den Schalenkern des Übertragers eingegossen werden, um gegen mechanische Zerstörung gut gesichert zu sein.

Anstelle einer zweiten Sekundärwicklung S21 kann auch, wie in Figur 5 angedeutet, ein massiver Metallring aus temperaturunabhängigem Widerstandsmaterial verwendet werden. Der niedrigere Eigenwiderstand dieses Ringes wird jedoch von der Primärseite aus um den Faktor 1/ü² vergrößert gemessen. Da 1/ü² gleich dem quadratischen Verhältnis der Primärwindungszahl zu der Sekundärwindungszahl ist und die Sekundärwindungszahl gleich 1 ist, wird der Faktor 1/ü² groß, er entspricht nämlich dann dem Quadrat der primärseitigen Windungszahl.

## Patentansprüche

1. Anordnung zum Kontrollieren des Widerstandes (Rz) einer an einem Übertrager (P, S) sekundärseitig angeschlossenen Last (R_{z}) - vorzugsweise der Zündpille eines Airbags-, **dadurch gekennzeichnet, daß** der Last (Rz) ein zusätzlicher Widerstand (R) parallelgeschaltet ist, dessen ohmscher Widerstandswert mindestens zehnmal so groß wie der des Widerstandes (Rz) der Last ist, und daß Mittel (ST) vorgesehen sind, welche den primärseitigen Eingangswiderstand (R1) des Übertragers (P, S) messen und bei Abweichung des Eingangswiderstandes (R1) von einem vorgegebenen Wert einen Fehler der Last signalisieren.

2. Anordnung nach Anspruch 1, **dadurch gekennzeichnet, daß** der zusätzliche Widerstand (R) in einem die Sekundärwicklung (S, S1, S2) des Übertragers aufnehmenden Schalenkern integriert ist.

3. Anordnung nach Anspruch 1, **dadurch gekennzeichnet, daß** für die Transformation der Last (Rz) und des zusätzlichen Widerstandes (R) auf die Primärseite des Übertragers zwei galvanisch getrennte Sekundärwicklungen (S1, S2, S21, S22) vorhanden sind.

4. Anordnung nach Anspruch 3, **dadurch gekennzeichnet, daß** die Sekundärwicklung (S21) für den zusätzlichen Widerstand (R) aus einem Draht gewickelt ist, der selbst diesen Widerstand aufweist, und daß die Anschlüsse der Sekundärwicklung (S21) miteinander kurzgeschlossen sind.

5. Anordnung nach Anspruch 1, **dadurch gekennzeichnet, daß** der zusätzliche Widerstand (R) als ein sekundärseitig angeordneter Ring (S22) ausgebildet ist.

## Claims

1. Arrangement for monitoring the resistance (Rz) of a load (Rz) - preferably the firing pellet of an airbag - connected to the secondary side of a transformer (P, S), **characterized in that** an additional resistor (R) is connected in parallel with the load (Rz), the non-reactive resistance value of which additional resistor is at least ten times as large as that of the resistance (Rz) of the load, and **in that** means (ST) are provided which measure the primary-side input resistance (R1) of the transformer (P, S) and signal a load fault in the event of the input resistance (R1) deviating from a predetermined value.

2. Arrangement according to Claim 1, **characterized in that** the additional resistor (R) is integrated in a pot-type core accommodating the secondary winding (S, S1, S2) of the transformer.

3. Arrangement according to Claim 1, **characterized in that** two DC-isolated secondary windings (S1, S2, S21, S22) are present for transforming the load (Rz) and the additional resistor (R) to the primary side of the transformer.

4. Arrangement according to Claim 3, **characterized in that** the secondary winding (S21) for the additional resistor (R) is wound from a wire which itself has this resistor, and **in that** the connections of the secondary winding (S21) are short-circuited to one another.

5. Arrangement according to Claim 1, **characterized in that** the additional resistor (R) is designed as a ring (S22) arranged on the secondary side.

## Revendications

1. Dispositif servant à contrôler la résistance (Rz) d'une charge (Rz) -de préférence l'amorce d'un coussin gonflableraccordée du côté secondaire à un transformateur (P, S)
**caractérisé en ce qu'**
- on monte en parallèle à la charge (Rz) une résistance additionnelle (R) dont la valeur ohmique de la résistance est au moins dix fois aussi grande que celle de la résistance (Rz) de la charge, et
- il est prévu des moyens (ST) qui mesurent la résistance d'entrée (R1), située du côté primaire, du transformateur (P,S) et qui, en cas d'écart de la résistance d'entrée (R1) par rapport à une valeur prédéfinie, signalent un défaut de la charge.

2. Dispositif selon la revendication 1,
**caractérisé en ce que**
la résistance additionnelle (R) est intégrée dans un noyau qui loge l'enroulement secondaire (S, S1, S2) du transformateur.

3. Dispositif selon la revendication 2,
**caractérisé en ce que**
pour la transformation de la charge (Rz) et de la résistance additionnelle (R) il est prévu sur le côté primaire du transformateur deux enroulements secondaires (S1, S2, S21, S22) séparés galvaniquement.

4. Dispositif selon la revendication 3,
**caractérisé en ce que**
- l'enroulement secondaire (S21) pour la résistance, additionnelle (R) est bobiné à partir d'un fil qui présente lui-même cette résistance, et
- les raccordements de l'enroulement secondaire (S21) sont mis l'un avec l'autre en court-circuit.

5. Dispositif selon la revendication 3,
**caractérisé en ce que**
la résistance additionnelle (R) est constituée sous la forme d'un anneau (S22) disposé du côté secondaire.
